# EUROPEAN PATENT APPLICATION

(11) **EP 2 615 072 A1**
(43) Date of publication of application: **17.07.2013**
(21) Application number: 12198945.3
(22) Date of filing: 21.12.2012
(51) Int. Cl.: C03C 17/34, C03C 17/36, C03C 17/42

(54) **Thermochromic substrate and method of manufacturing the same**

(30) Priority: 26.12.2011 KR 20110142055
(71) Applicant: Samsung Corning Precision Materials Co., Ltd., Gyeongsangbuk-do Gumi-si, 730-735 (KR)
(72) Inventor: Bae, Seulgi, 336-841 Asan-si ChungCheongNam-Do (KR); Moon, Dong-Gun, 336-841 Asan-si ChungCheongNam-Do (KR); Ryu, Sang-Ryoun, 336-841 Asan-si ChungCheongNam-Do (KR)
(74) Representative: Gulde Hengelhaupt Ziebig & Schneider

(57) **Abstract**

A thermochromic substrate that has a thermochromic thin film, and a method of manufacturing the same. The thermochromic substrate includes a base substrate, an oxide or nitride thin film formed on the base substrate, a vanadium dioxide (VO₂) thin film formed on the oxide or nitride thin film, and a photochromic thin film formed on the VO₂ thin film.

## Description

### CROSS REFERENCE TO RELATED APPLICATION

The present application claims priority from Korean Patent Application Number 10-2011-0142055 filed on December 26, 2012, the entire contents of which application are incorporated herein for all purposes by this reference.

### BACKGROUND OF THE INVENTION

### Field of the Invention

The present invention relates to a thermochromic substrate and a method of manufacturing the same, and more particularly, to a thermochromic substrate that has a thermochromic thin film and a method of manufacturing the same.

### Description of Related Art

Thermochromism refers to the phenomenon in which an oxide or a sulfide of a transition metal undergoes a change in its crystalline structure below and above a specific temperature (i.e. its transition temperature (Tc)), whereby its physical properties (electrical conductivity and infrared (IR) transmittance) suddenly change.

When a glass is coated with a thin film that has such thermochromic capability, a "smart window" can be produced, which transmits visible light but blocks near infrared rays and infrared rays at or above a predetermined temperature in order to prevent the indoor temperature from increasing. The application of smart windows to vehicles or buildings may be very effective in saving energy. Materials that exhibit thermochromism include oxides of several transition metals, of which vanadium dioxide (VO₂) is being studied since its transition temperature is 68°C, which is relatively close to a temperature at which practical application becomes possible.

Vanadium oxides, such as VO₂, are present in the form of a variety of crystalline phases, such as V₂O₃, V₃O₅, V₄O₇, V₆O₁₁, V₅O₉, V₆O₁₃, V₄O₉, V₃O₇, V₂O₅ and VO₂. The thermochromic characteristics appear in the crystalline phase of VO₂.

Therefore, in order to transform vanadium oxides that are present in a variety of crystalline phases, such as V₂O₃, V₃O₅, V₄O₇, V₅O₉, V₆O₁₁, V₆O₁₃, V₄O₉, V₃O₇, V₂O₅ and VO₂, into VO₂ in the crystalline phase, a method of heating a glass substrate to a high temperature and then coating the glass substrate with a vanadium oxide, a method of coating a glass substrate with a vanadium oxide, followed by post annealing, and the like are used.

The thermochromic glass using the VO₂ thin film has a yellowish color due to the unique color of VO₂.

However, as a drawback, when the thermochromic glass is applied to the construction industry, the thermochromic glass using the VO₂ thin film is not compliant with consumers' demands, since consumers prefer greenish, bluish or grayish colors.

The information disclosed in this Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a thermochromic substrate, the color of which satisfies consumers' demands, and a method of manufacturing the same.

In an aspect of the present invention, provided is a thermochromic substrate that includes a base substrate; a thermochromic thin film formed on the base substrate; and a photochromic thin film formed on the thermochromic thin film.

In an exemplary embodiment, the photochromic thin film may absorb wavelengths ranging from 380nm to 780nm, and be made of at least one substance selected from among silver (Ag), Ag halide, zinc (Zn) halide, spiropyran and diarylethene.

In an exemplary embodiment, the thermochromic thin film may contain at least one selected from among vanadium dioxide (VO₂), titanium oxide (III) (Ti₂O₃) and niobium oxide (NbO₂).

In an exemplary embodiment, the thermochromic thin film may be doped with at least one substance selected from among molybdenum (Mo), tungsten (W), chromium (Cr), nickel (Ni) and zirconium (Zr).

In an exemplary embodiment, the thermochromic substrate may further include an oxide or nitride thin film between the base substrate and the thermochromic substrate.

In an exemplary embodiment, the oxide or nitride thin film may be made of at least one selected from among silicon dioxide (SiO₂), aluminum oxide (Al₂O₃), niobium pentoxide (Nb₂O₅), titanium dioxide (TiO₂), and silicon nitride (Si₃N₄). It is preferred that the thickness of the oxide or nitride thin film range from 30nm to 80nm.

In another aspect of the present invention, provided is a method of manufacturing a thermochromic substrate that includes the following steps of: forming an oxide or nitride thin film as a coating on a glass substrate; forming a VO₂ thin film as a coating on the oxide or nitride thin film; and forming a photochromic thin film as a coating on the VO₂ thin film.

In an exemplary embodiment, the step of forming the VO₂ thin film may be carried out using a sputtering target made of VO₂ that is doped with at least one substance selected from among Mo, W, Cr, Ni and Zr, or using a sputtering target made of VO₂ and a sputtering a sputtering target made of at least one selected from among Mo, W, Cr, Ni and Zr.

In an exemplary embodiment, the step of forming the photochromic thin film may be carried out by direct-current (DC) sputtering deposition or sol-gel processing.

According to embodiments of the invention, the color of the thermochromic substrate can be adjusted such that it satisfies consumers' demands, and can be preferably adjusted such that the thermochromic substrate has a grayish color.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a schematic cross-sectional view schematically depicting a thermochromic substrate according to an exemplary embodiment of the invention;

FIG. 2 is a graph depicting the absorptivity of molybdenum (VI) oxide (MoO₃) as a photochromic material depending on light irradiation time;

FIG. 3 is a graph depicting the transmittance of a lens coated with a photochromic material;

FIG. 4 is a graph depicting the transmittances of a vanadium dioxide (VO₂) thin film, a photochromic thin film, and a multilayer film, which includes a VO₂ thin film and a photochromic thin film stacked on the VO₂ thin film, according to an embodiment of the invention; and

FIG. 5 is a flowchart schematically depicting a method of manufacturing a thermochromic substrate according to an exemplary embodiment of the invention.

### DETAILED DESCRIPTION OF THE INVENTION

Reference will now be made in detail to a thermochromic substrate that has a thermochromic thin film and a method of manufacturing the same of the present invention, embodiments of which are illustrated in the accompanying drawings and described below.

In the following description of the present invention, detailed descriptions of known functions and components incorporated herein will be omitted when they may make the subject matter of the present invention unclear.

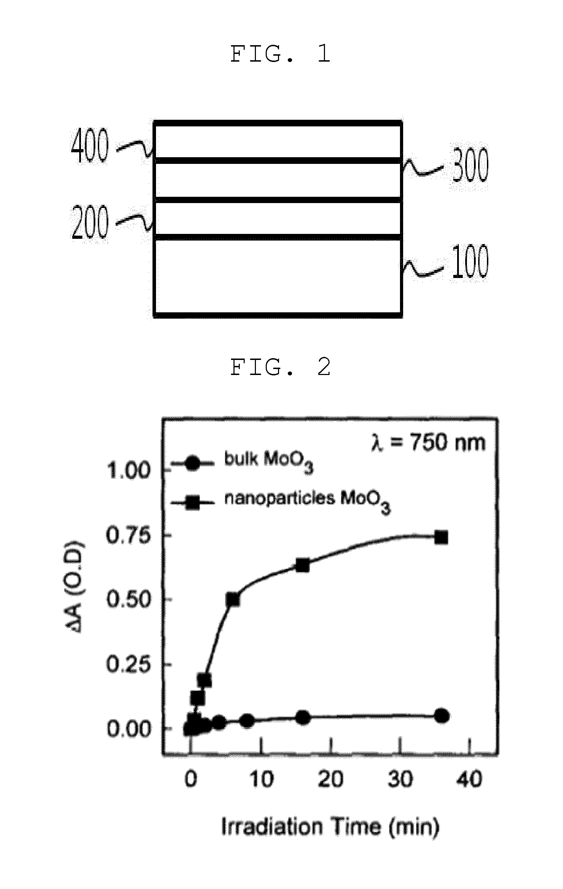

FIG. 1 is a schematic cross-sectional view schematically depicting a thermochromic substrate according to an exemplary embodiment of the invention.

Referring to FIG. 1, the thermochromic substrate according to an exemplary embodiment of the invention includes a glass substrate 100, an oxide or nitride thin film 200, a vanadium dioxide (VO₂) thin film 300, and a photochromic thin film 400.

The glass substrate 100 is a transparent or color substrate that has a predetermined area or thickness. It is preferred that the glass substrate be a sodalime glass.

The oxide or nitride thin film 200 is formed on the glass substrate 100, and acts as a sodium diffusion barrier to prevent sodium (Na) ions in the glass substrate from diffusing into the VO₂ thin film 300, which will be described later, at a temperature of 350°C or higher in the process of manufacturing the thermochromic substrate. Otherwise, the VO₂ thin film would lose the thermochromic characteristics due to the sodium diffusion.

The oxide or nitride thin film 200 may be made of one material selected from among, but not limited to, silicon dioxide (SiO₂), niobium pentoxide (Nb₂O₅), aluminum oxide (Al₂O₃) titanium dioxide (TiO₂), and silicon nitride (Si₃N₄). Although it is preferred that the thickness of the oxide or nitride thin film 200 range from 30nm to 80nm, the thickness may vary depending on the type of materials to be coated, the refractivity of coating materials, and the like.

The VO₂ thin film 300 is formed on the oxide or nitride thin film 200, and undergoes phase transition depending on the temperature, thereby adjusting the transmittance of infrared (IR) radiation.

The transition of the VO₂ thin film 300 occurs at a predetermined temperature, at which the crystalline structure of VO₂ changes due to the thermochromic phenomenon, so that the physical properties (electrical conductivity and infrared radiation transmittance) of the VO₂ thin film drastically change. As a result, the VO₂ thin film 300 blocks near IR radiation and IR radiation while allowing visible light to pass through.

The VO₂ thin film 300 may be doped with a dopant in order to reduce the phase transition of VO₂. It is preferred that the VO₂ thin film be doped with at least one selected from among molybdenum (Mo), tungsten (W), chromium (Cr), nickel (Ni) and zirconium (Zr).

The photochromic thin film 400 is formed on the VO₂ thin film 300 such that it adjusts the color of the photochromic substrate.

When the photochromic thin film 400 is irradiated with light, the joining structure of its chemical substance changes, thereby forming an isomer having a different absorption spectrum. As a result, the color of the thin film reversibly changes.

FIG. 2 is a graph depicting the absorptivity of molybdenum (VI) oxide (MoO₃) as a photochromic material depending on light irradiation time. As shown in FIG. 2, it can be appreciated that the light absorptivity of the photochromic material changes depending on light irradiation time, and that the color of the photochromic material changes due to the changed light absorptivity.

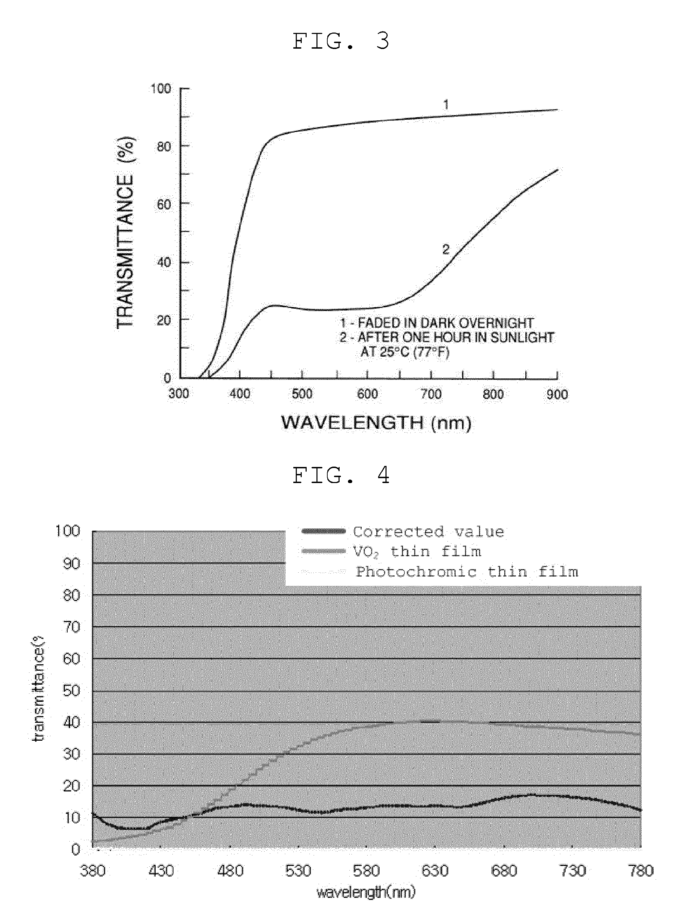

FIG. 3 is a graph depicting the transmittance of a lens coated with a photochromic material. As shown in FIG. 3, it can be appreciated that the color of the photochromic lens changes during the daytime when ultraviolet (UV) radiation is radiated thereon, whereby the transmittance of the photochromic lens decreases.

It is preferred that the photochromic thin film 400 according to an embodiment of the invention absorb wavelengths ranging from 380nm to 780nm, so that the thermochromic substrate has a grayish color.

A material that absorbs wavelengths ranging from 380nm to 780nm may be implemented as at least one material selected from among silver (Ag), Ag halide, zinc (Zn) halide, spiropyran and diarylethene.

In this way, it is possible to adjust the color of the thermochromic substrate by coating the VO₂ thin film having a yellowish color with the photochromic thin film.

In particular, it is possible to manufacture a thermochromic substrate having a grayish color, which will be popular to consumers when applied to the construction industry, by coating a VO₂ thin film with a photochromic thin film that absorbs wavelengths ranging from 380nm to 780nm.

That is, when a VO₂ thin film has a yellowish color, with a being within ±5 and b being 10 or more according to the CIE L*a*b* color system, it is possible to impart the thermochromic substrate with a grayish color, in which a is within ±5 and b is 15 or less, by coating the VO₂ thin film with a photochromic thin film that absorbs wavelengths ranging from 380nm to 780nm.

### Table 1

Table 1 above is a table that presents a and b values of a VO₂ thin film and a photochromic thin film and corrected a and b values of a multilayer film that is formed using the VO₂ thin film and the photochromic thin film.

**Table 1**

| | a* | b* | After color correction | |
|---|---|---|---|---|
| | | | a* | b* |
| VO₂ thin film | -1.309 | 41.211 | 0.558 | 12.736 |
| Photochromic thin film | 8.647 | -25.31 | | |

As presented in Table 1 above, it is possible to manufacture the thermochromic substrate having a grayish color by significantly reducing the b value by coating the VO₂ thin film that has a yellowish color with the photochromic thin film, in which a is 8.648 and b is -25.31 in the CIE L*a*b* color system.

FIG. 4 is a graph depicting the transmittances of a VO₂ thin film, a photochromic thin film, and a multilayer film, which includes a VO₂ thin film and a photochromic thin film stacked on the VO₂ thin film, according to an embodiment of the invention. As shown in FIG. 4, the VO₂ thin film has a high transmittance at wavelengths of 480nm or longer, whereas the multilayer film according to an embodiment of the invention can realize a grayish color due to the transmittance thereof being reduced to a predetermined level.

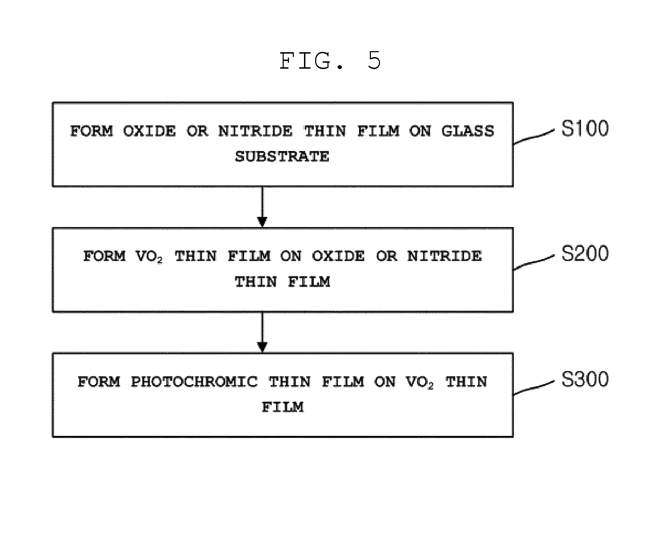

FIG. 5 is a flowchart schematically depicting a method of manufacturing a thermochromic substrate according to an exemplary embodiment of the invention.

Referring to FIG. 5, the method of manufacturing the thermochromic substrate according to an exemplary embodiment of the invention may include the steps of: forming an oxide or nitride thin film as a coating on a glass substrate (S100), forming a VO₂ thin film as a coating on the oxide or nitride thin film via sputtering deposition (S200), and forming a photochromic thin film as a coating on the VO₂ thin film.

Here, the VO₂ thin film may be formed via sputtering deposition using a sputtering target made of VO₂ that is doped with at least one substance selected from among Mo, W, Cr, Ni and Zr, or co-sputtering deposition using a sputtering target made of VO₂ and a sputtering target made of at least one substance selected from among Mo, W, Cr, Ni and Zr.

In addition, the photochromic thin film may be made via direct current (DC) sputtering deposition or sol-gel processing.

The foregoing descriptions of specific exemplary embodiments of the present invention have been presented with respect to the certain embodiments and drawings. They are not intended to be exhaustive or to limit the invention to the precise forms disclosed, and obviously many modifications and variations are possible for a person having ordinary skill in the art in light of the above teachings.

It is intended therefore that the scope of the invention not be limited to the foregoing embodiments, but be defined by the Claims appended hereto and their equivalents.

## Claims

1. A thermochromic substrate comprising:
a base substrate;
a thermochromic thin film formed on the base substrate; and
a photochromic thin film formed on the thermochromic thin film.

2. The thermochromic substrate of claim 1, wherein the photochromic thin film is adapted to absorb light with wavelengths ranging from 380nm to 780nm.

3. The thermochromic substrate according to one of the preceding claims, wherein the photochromic thin film comprises at least one selected from the group consisting of silver (Ag), silver (Ag) halide, zinc (Zn) halide, spiropyran and diarylethene.

4. The thermochromic substrate according to one of the preceding claims, wherein the thermochromic thin film comprises at least one selected from the group consisting of vanadium dioxide (VO₂), titanium oxide (III) (Ti₂O₃) and niobium oxide (NbO₂).

5. The thermochromic substrate according to one of the preceding claims, wherein the thermochromic thin film comprises a thermochromic material and a dopant doping into the thermochromic material such that a phase transition temperature of the thermochromic thin film is lower than a phase transition temperature of the thermochromic material.

6. The thermochromic substrate of claim 5, wherein the dopant comprises at least one selected from the group consisting of molybdenum (Mo), tungsten (W), chromium (Cr), nickel (Ni) and zirconium (Zr).

7. The thermochromic substrate according to one of the preceding claims, further comprising an oxide or nitride thin film between the base substrate and the thermochromic thin film.

8. The thermochromic substrate of claim 7, wherein the oxide or nitride thin film comprises at least one selected from the group consisting of silicon dioxide (SiO₂), aluminum oxide (Al₂O₃), niobium pentoxide (Nb₂O₅), titanium dioxide (TiO₂), and silicon nitride (Si₃N₄).

9. The thermochromic substrate according to one of claims 7 and 8, wherein a thickness of the oxide or nitride thin film ranges from 30nm to 80nm.

10. A method of manufacturing a thermochromic substrate, comprising:
coating a base substrate with a thermochromic thin film; and
coating the thermochromic thin film with a photochromic thin film.

11. The method of claim 10, wherein the thermochromic thin film is formed using a sputtering target that comprises vanadium dioxide (VO₂), the vanadium dioxide (VO₂) being doped with at least one selected from the group consisting of molybdenum (Mo), tungsten (W), chromium (Cr), nickel (Ni) and zirconium (Zr).

12. The method according to one of claims 10 and 11, wherein the thermochromic thin film is formed using a sputtering target that comprises vanadium dioxide (VO₂) and a sputtering target that comprises at least one selected from the group consisting of molybdenum (Mo), tungsten (W), chromium (Cr), nickel (Ni) and zirconium (Zr).

13. The method according to one of claims 10 to 12, wherein coating the thermochromic thin film with a photochromic thin film uses direct-current (DC) sputtering deposition or sol-gel processing.
